# EUROPEAN PATENT APPLICATION

(11) **EP 4 481 798 A1**
(43) Date of publication of application: **25.12.2024**
(21) Application number: 23755658.4
(22) Date of filing: 19.01.2023
(51) Int. Cl.: H01L 21/67

(54) **SUBSTRATE CLEANING APPARATUS AND TURN-OVER DEVICE THEREOF**

(30) Priority: 15.02.2022 CN 202210138646
(71) Applicant: ACM Research (Shanghai), Inc., Shanghai 201203 (CN)
(72) Inventor: LI, Yazhou, Shanghai 201203 (CN); WANG, He, Shanghai 201203 (CN); GUO, Zhenghui, Shanghai 201203 (CN); TAO, Xiaofeng, Shanghai 201203 (CN); JIA, Shena, Shanghai 201203 (CN); WANG, Hui, Shanghai 201203 (CN)
(74) Representative: Osha BWB
(86) International application number: PCT/CN2023/073029
(87) International publication number: WO 2023/155654

(57) **Abstract**

The present invention provides a substrate cleaning apparatus and a turn-over device thereof. The substrate turn-over device comprises a tank, a lifting mechanism and a turn-over mechanism. The lifting mechanism is arranged on one side of the tank and is configured to receive a substrate and drive the substrate to ascend and descend. The turn-over mechanism is arranged on the tank, and is used for overturning the substrate, and is configured to move between a substrate-receiving position and a substrate-taking position relative to the lifting mechanism, wherein the substrate-receiving position is a position where the turn-over mechanism receives the substrate from the lifting mechanism, and the substrate-taking position is a position where the substrate is taken from the turn-over mechanism. In the present invention, a plurality of substrates that have completed tank cleaning can be transferred to the lifting mechanism in one step, and are quickly transferred to a process manipulator in multiple steps by the turn-over mechanism, which can not only shorten the residence time that the substrates that have completed tank cleaning in the substrate cleaning tank, and thus improve the efficiency of the substrate cleaning apparatus, but can also increase the transferring speed of the substrate turn-over device.

## Description

### BACKGROUND OF THE INVENTION

### Field of the Invention

The present invention relates to the field of semiconductor manufacturing, in particular to a substrate cleaning apparatus and a turn-over device thereof.

### The Related Art

In the substrate cleaning process, in order to give consideration to cleaning efficiency and effect, tank cleaning process and single substrate cleaning process are usually combined.

The substrate cleaning apparatus includes a plurality of substrate cleaning tanks, a plurality of single substrate cleaning chambers, turn-over devices, and a plurality of manipulators. The plurality of manipulators includes a first manipulator, a second manipulator, and a process manipulator, wherein the first manipulator is responsible for transferring the substrate to the plurality of substrate cleaning tanks, the second manipulator is responsible for taking out the substrate from the substrate cleaning tank and transferring the substrate to a turn-over device, and the process manipulator is responsible for taking out the substrate from the turn-over device and transferring the substrate to the single substrate cleaning chamber.

The substrate cleaning tanks are configured to batch process a plurality of vertically placed substrates. The single substrate cleaning chamber is configured to process one horizontally placed substrate at a time. The turn-over device is configured to rotate the substrate that has completed tank cleaning in the substrate cleaning tank from the vertical direction to the horizontal direction so as to facilitate the process manipulator to horizontally transfer the substrate to the single substrate cleaning chamber.

Based on factors such as cost and transmission stability, the process manipulator is usually equipped with two robotic arms, which transfer two substrates at a time. The substrates are exposed to the air in the turn-over device, and contaminants such as airborne particles easily adhere to the surface of the substrates. In order to reduce the waiting time of the substrates in the turn-over device, the number of substrates overturned by the turn-over device each time does not exceed the number of substrates taken by the process manipulator, that is, the turn-over device overturns one or two substrates each time. Accordingly, the second manipulator takes out one or two substrates from the substrate cleaning tank each time and places them in the turn-over device, so that the substrates transferred by the second manipulator to the turn-over device can be transferred to the single substrate cleaning chamber by the process manipulator in time. However, the substrate cleaning tank is a batch processing equipment, and 7, 13, 25 or more substrates are processed at a time. Therefore, after a batch of substrates have completed cleaning in the substrate cleaning tank, it is necessary to repeat the second manipulator to take the substrates, overturn by the turn-over device and transfer the substrates by the process manipulator for many times, so that the plurality of substrates in a batch can be transferred to the plurality of single substrate cleaning chambers. It will prolong the occupation time of the substrates in the substrate cleaning tank, reduce the transmission efficiency of the substrate, and affect the output of the substrate cleaning equipment per unit time.

### SUMMARY

The purpose of the present invention is to provide a substrate turn-over device, which can solve the problem that the substrate transmission efficiency of the substrate turn-over device in the prior art is low, which influences the output amount of the substrate cleaning apparatus per unit time. At the same time, it can ensure that the substrate is kept wet in the substrate turn-over device, and reduce the adhesion of the contaminants such as particles.

To achieve the above object, the present invention provides a substrate turn-over device, comprising:
a tank, for holding liquid;
a lifting mechanism, arranged on one side of the tank, configured to receive the substrate and drive the substrate up and down so as to submerge the substrate in the liquid of the tank or lift the substrate from the tank;
a turn-over mechanism, arranged on the tank for overturning the substrate and configured to move between a substrate-receiving position and a substrate-taking position relative to the lifting mechanism, the substrate-receiving position being a position where the turn-over mechanism receives the substrate from the lifting mechanism, and the substrate-taking position being a position where the substrate is taken out from the turn-over mechanism.

Another object of the present invention is to provide a substrate cleaning apparatus that improves transmission efficiency and output per unit time of the substrate cleaning apparatus. In order to achieve the object, the present invention provides a substrate cleaning apparatus comprising:
a tank cleaning module, comprising a first turn-over device, at least one substrate cleaning tank, at least one manipulator and a second turn-over device, the at least one substrate cleaning tank being used for performing a tank cleaning process on the substrate, the first turn-over device being used for overturning the substrate from a horizontal direction to a vertical direction, the at least one manipulator being responsible for vertically transferring the substrate for the first turn-over device, at least one substrate cleaning tank and the second turn-over device, and the second turn-over device being used for overturning the substrate that has completed tank cleaning from the vertical direction to the horizontal direction;
a single substrate cleaning module, comprising at least one single substrate cleaning chamber for performing single substrate cleaning process and drying process on the substrate;
a process manipulator, taking the substrate from the second turn-over device and horizontally transferring the substrate into at least one single substrate cleaning chamber of the single substrate cleaning module;
wherein, the second turn-over device adopts the substrate turn-over device according to any one of the above items.

In the present invention, the substrates after the tank cleaning can be transferred to the lifting mechanism at one time, and the residence time of the substrates in the substrate cleaning tank can be reduced, thereby increasing the output of the substrate cleaning apparatus.

At the same time, the turn-over mechanism is configured to not only rotate the substrate from the vertical direction to the horizontal direction, but also translate relative to the lifting mechanism, and move back and forth at the substrate-receiving position and the substrate-taking position, so as to quickly transfer the plurality of substrates on the lifting mechanism to the process manipulator in several times, which is beneficial to improve the transferring speed of the substrate turn-over device.

In addition, when the turn-over mechanism transfers the substrates to the process manipulator, the substrates stayed on the lifting mechanism can descend and be immersed in the tank with the lifting mechanism and remain wet, thereby shortening the exposure time of the substrate in the air and avoiding the contaminants such as particles in the air from contaminating the surface of the substrate.

### BRIEF DESCRIPTION OF THE DRAWINGS

Fig. 1 is a perspective view of a substrate turn-over device according to a first embodiment of the present invention.
Fig. 2 is a cross-sectional view of a tank according to the first embodiment of the present invention;
Fig. 3 is a partial enlarged view at A in Fig. 2;
Fig. 4 is a perspective view of a lifting mechanism according to the first embodiment of the present invention.
Fig. 5 is a partial enlarged view at B in Fig. 4;
Fig. 6 is a perspective view of the substrate turn-over device according to the first embodiment of the present invention, wherein the housing of the turn-over mechanism is hidden;
Fig. 7 is a perspective view of the turn-over mechanism according to the first embodiment of the present invention, wherein the housing of the turn-over mechanism is hidden;
Fig. 8 is a perspective view of the turn-over mechanism according to the first embodiment of the present invention.
Fig. 9 is a perspective view from another perspective of the turn-over mechanism according to the first embodiment of the present invention;
Fig. 10 is a perspective view of a substrate holder according to the first embodiment of the present invention;
Fig. 11 is a cross-sectional view of the substrate holder of Fig. 10 along the X direction;
Fig. 12 is a partial enlarged view at C of Fig. 11;
Fig. 13 is a schematic diagram showing a manipulator placing a substrate onto a support seat when the substrate turn-over device according to the first embodiment of the present invention is in an initial state;
Figs. 14 (a) ~ 14 (h) show an operational flow for transferring the substrate to the process manipulator by the substrate turn-over device according to the first embodiment of the present invention, wherein the substrate holder receives the substrate from the support seat for the first time;
Figs. 15 (a) ~ 15 (h) show an operation flow of transferring the substrate to the process manipulator by the substrate turn-over device according to the first embodiment of the present invention, wherein the substrate holder receives the substrate from the support seat for the second time; and
Fig. 16 is a plan view of a substrate cleaning apparatus according to a second embodiment of the present invention.

### DETAILED DESCRIPTION OF EMBODIMENTS

In order to explain the technical content, structural features, achieved objects, and effects of the present invention in detail, the following will be described in detail with reference to embodiments and drawings.

### First embodiment

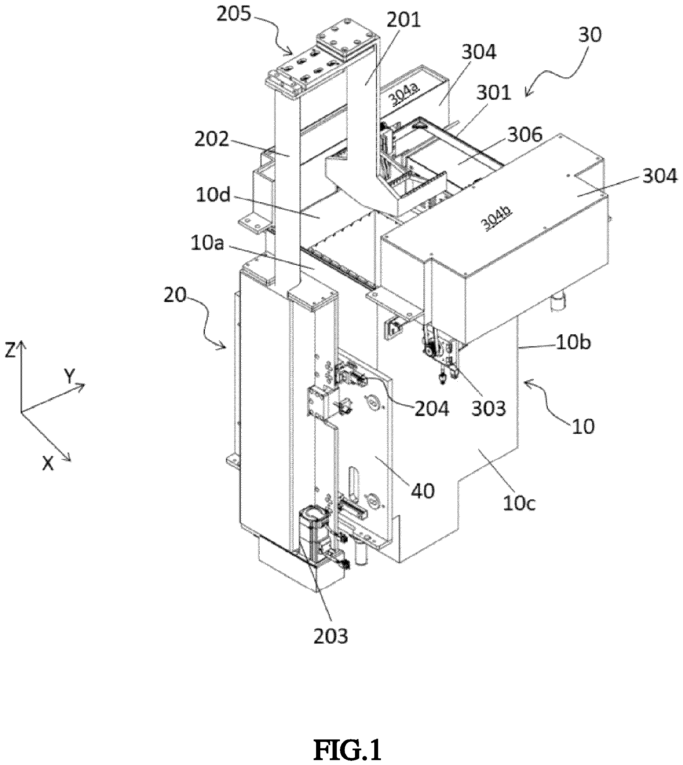

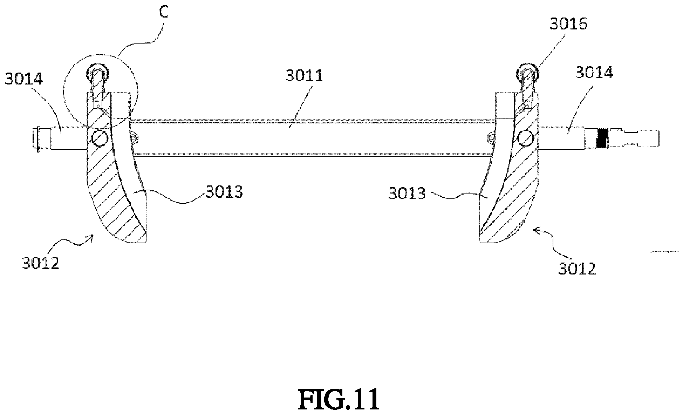

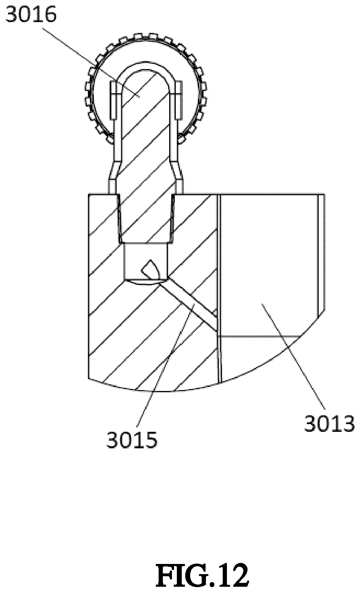

Figs. 1 to 12 disclose a substrate turn-over device according to the first embodiment of the present invention. The substrate turn-over device is arranged between the tank cleaning module and the single substrate cleaning module for overturning the substrate in the vertical direction into the substrate in the horizontal direction, so as to facilitate the process manipulator to horizontally transfer the substrate to the single substrate cleaning module. Fig. 1 shows a structural diagram of the substrate turn-over device in the present embodiment, and the substrate turn-over device mainly includes a tank 10, a lifting mechanism 20, and a turn-over mechanism 30.

The tank 10 is used to hold liquid. The lifting mechanism 20 is provided on one side of the tank 10, and is configured to receive the substrate and drive the substrate up and down so that the substrate is immersed in the liquid of the tank 10 or lifted from the tank 10. The turn-over mechanism 30 is disposed on the tank 10 for overturning the substrate. Preferably, the turn-over mechanism 30 is disposed on the top part of the tank 10. The turn-over mechanism 30 is configured to move between a substrate-receiving position and a substrate-taking position relative to the lifting mechanism 20, wherein the substrate-receiving position is a position where the turn-over mechanism 30 receives the substrate from the lifting mechanism 20, and the substrate-taking position is a position where the substrate is taken out from the turn-over mechanism 30.

As shown in Fig. 1, the top opening of the tank 10 is generally square in shape, comprising a first sidewall 10a and a second sidewall 10b disposed oppositely, and a third sidewall 10c and a fourth sidewall 10d disposed oppositely. The tank 10 is used to hold liquid, such as deionized water, carbon dioxide deionized water, or the like.

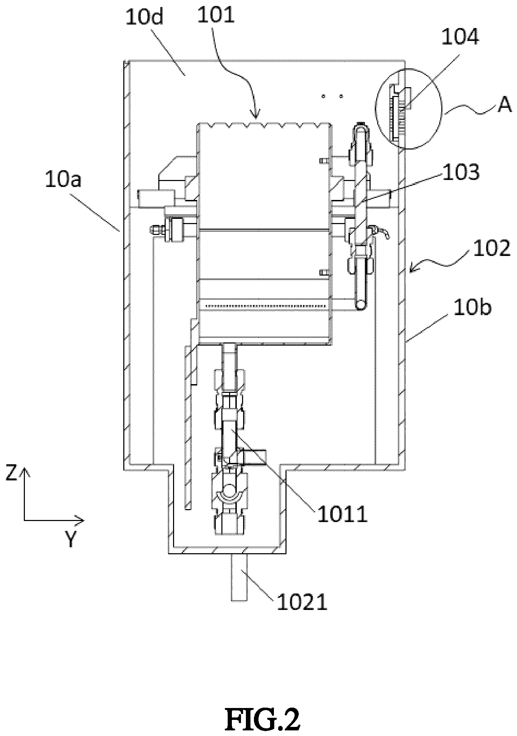

Fig. 2 shows a cross-sectional view of the tank. As shown in Fig. 2, the tank 10 includes an inner tank 101, an outer tank 102, and a liquid supply line 103 through which liquid is supplied to the inner tank 101. The inner tank 101 is disposed in the outer tank 102. The upper edge of the inner tank 101 is lower than the upper edge of the outer tank 102, and the liquid in the inner tank 101 can overflow into the outer tank 102 through the upper edge of the inner tank 101. In addition, the bottom of the inner tank 101 is provided with a first liquid discharge pipeline 1011 connected with the outer tank 102. The bottom of the outer tank 102 is provided with a second liquid discharge pipeline 1021 connected with the facility liquid discharge system. The liquid in the inner tank 101 can be quickly discharged through the first liquid discharge pipeline 1011 and the second liquid discharge pipeline 1021.

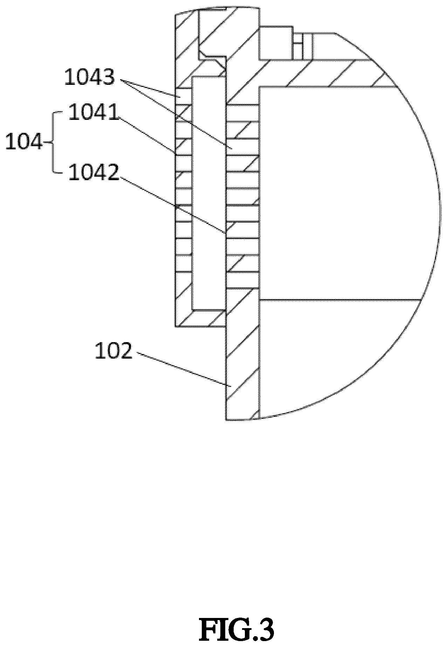

In order to ensure the cleanliness of the interior area of the tank 10, the tank 10 is further provided with an exhaust port. In the first embodiment, as shown in Fig. 2, an exhaust port 104 is provided on the outer tank 102, and the exhaust port 104 is connected to the facility exhaust system to continuously discharge the air in the interior area of the tank 10. Since liquid such as deionized water is contained in the tank 10, water mist may exist in the interior area of the tank 10. If the water mist is sucked into the facility exhaust system, it will cause damage to the pipe or fan of the facility exhaust system. In order to solve this problem, the exhaust port 104 is provided with a double-layered structure, as shown in Fig. 3, including a first exhaust plate 1041 and a second exhaust plate 1042. A cavity is formed between the first exhaust plate 1041 and the second exhaust plate 1042, and the first exhaust plate 1041 and the second exhaust plate 1042 are provided with staggered exhaust holes 1043, which can play a certain role in intercepting the water mist in the air, and reduce the water mist sucked into the exhaust system.

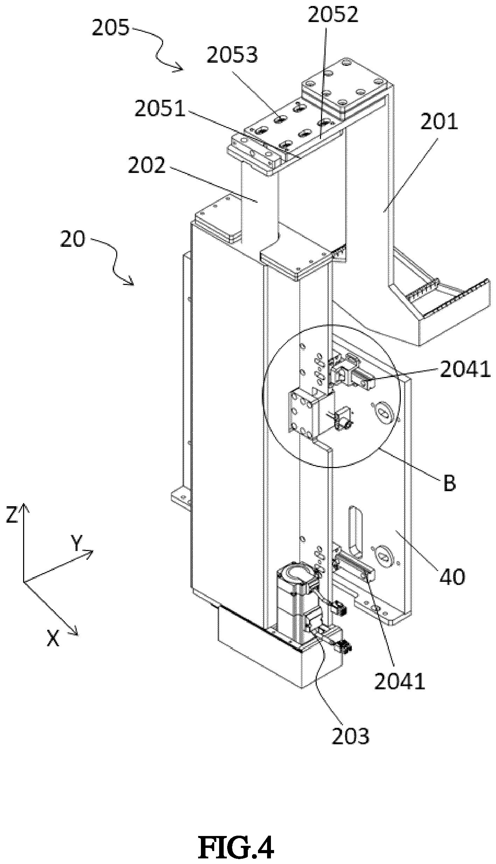

Fig. 4 shows a structural diagram of the lifting mechanism. As shown in Fig. 4, the lifting mechanism 20 includes a support seat 201, a support rod 202, and a first driving assembly 203. One end of the support seat 201 is used to receive the substrate, and the other end of the support seat 201 is fixed on the support rod 202. The first driving assembly 203 drives the support seat 201 up and down through the support rod 202, so that the support seat 201 is immersed in the liquid of the tank 10 or lifted from the tank 10. In the first embodiment, the first driving assembly 203 includes a driving motor and a lead screw, and the driving motor drives the support seat 201 up and down through the lead screw and the support rod 202. Of course, in other embodiments, the first driving assembly 203 can also use other linear transmission mechanisms, such as linear motors.

The support seat 201 is used to receive a plurality of substrates transferred from the manipulator, and typically, the support seat 201 can receive 7, 13, or 25 substrates. When the first driving assembly 203 drives the support seat 201 to descend into the tank 10, the substrate placed on the support seat 201 can be immersed in liquid such as deionized water in the tank 10 to ensure that the surface of the substrate is in a wet state.

The lifting mechanism 20 is further equipped with a micro-adjusting assembly, through which the installation positions of the lifting mechanism 20 and the support seat 201 can be micro-adjusted so that the support seat 201 faces the substrate-placing position to ensure that the support seat 201 can accurately receive a plurality of substrates transferred by the manipulator. Herein, the substrate-placing position is a position where the support seat 201 receives the substrate from the manipulator. Referring to Fig. 4, the micro-adjusting assembly may include a first micro-adjusting assembly 204 and/or a second micro-adjusting assembly 205. The lifting mechanism 20 is integrally mounted on a mounting plate 40 by a first micro-adjusting assembly 204 to adjust the mounting position of the lifting mechanism 20 in the first direction so that the support seat 201 faces the substrate-placing position, and the mounting plate 40 may be disposed parallel to the sidewall of the tank 10. The support seat 201 is mounted on the support rod 202 by the second micro-adjusting assembly 205 so as to adjust the mounting position of the support seat 201 in the second direction so that the support seat 201 faces the substrate-placing position.

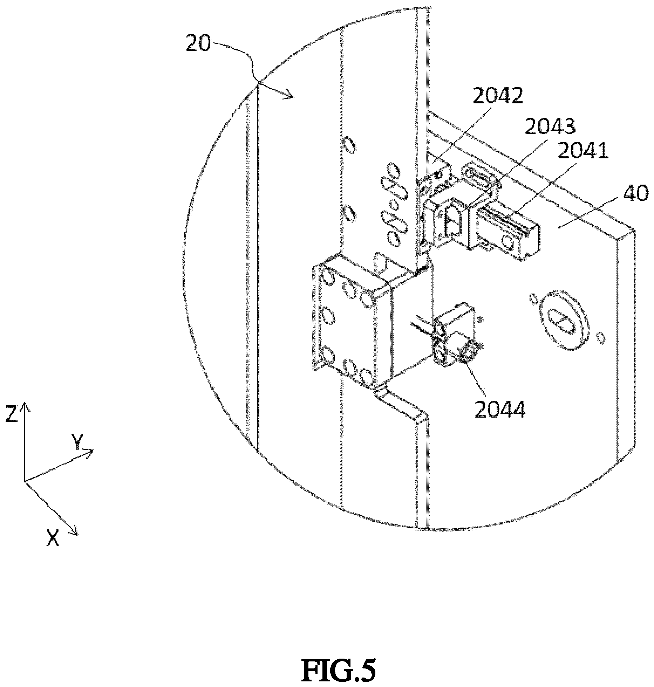

In the first embodiment, as shown in Fig. 1, the micro-adjusting assembly includes a first micro-adjusting assembly 204 and a second micro-adjusting assembly 205. The mounting plate 40 is disposed in parallel on the outside of the first sidewall 10a of the tank 10. The first direction and the second direction are perpendicular to each other in a horizontal plane, specifically, the first direction being a horizontal X direction, and the second direction being a horizontal Y direction. Referring to Figs. 4 and 5, a first micro-adjusting assembly 204 is disposed on the mounting plate 40 and includes a transverse guide rail 2041, a slider 2042, a first fastener 2043, and a micro-adjusting set screw 2044. The transverse guide rail 2041 is disposed on the mounting plate 40 along the horizontal X direction. The lifting mechanism 20 is slidably mounted on the transverse guide rail 2041 by a slider 2042. The micro-adjusting set screw 2044 is disposed on the mounting plate 40, and one end of the micro-adjusting set screw 2044 is in contact with the lifting mechanism 20. The micro-adjusting set screw 2044 can push the lifting mechanism 20 to move along the transverse guide rail 2041. When the lifting mechanism 20 is adjusted to a predetermined position in the horizontal X direction, the lifting mechanism 20 is fixed at the predetermined position by the first fastener 2043, that is, the adjustment of the installation position of the lifting mechanism 20 in the horizontal X direction is completed. In order to improve the mounting stability of the lifting mechanism 20 on the mounting plate 40, a plurality of transverse guide rails 2041 can be provided, and the plurality of transverse guide rails 2041 can be provided in parallel. In the first embodiment, as shown in Figs. 1 and 4, two transverse guide rails 2041 are arranged at intervals along the vertical direction of the mounting plate 40.

Please refer again to Fig. 4, the second micro-adjusting assembly 205 includes a first adjustment member 2051 and a second adjustment member 2052 arranged in the horizontal Y direction. One end of the first adjustment member 2051 is fixed on the support rod 202. One end of the second adjustment member 2052 is fixed on the support seat 201. Both of the first adjustment member 2051 and the second adjustment member 2052 are provided with adjustment holes 2053, and a second fastener passes through overlapping portions of the adjustment holes 2053 of the first adjustment member 2051 and the second adjustment member 2052 to fix the two together. The adjustment holes 2053 are provided as long waist holes. By changing the overlapping length of the first adjusting member 2051 and the second adjusting member 2052, the position of the support seat 201 in the horizontal Y direction is changed, thereby realizing the adjustment of the mounting position of the support seat 201 in the horizontal Y direction.

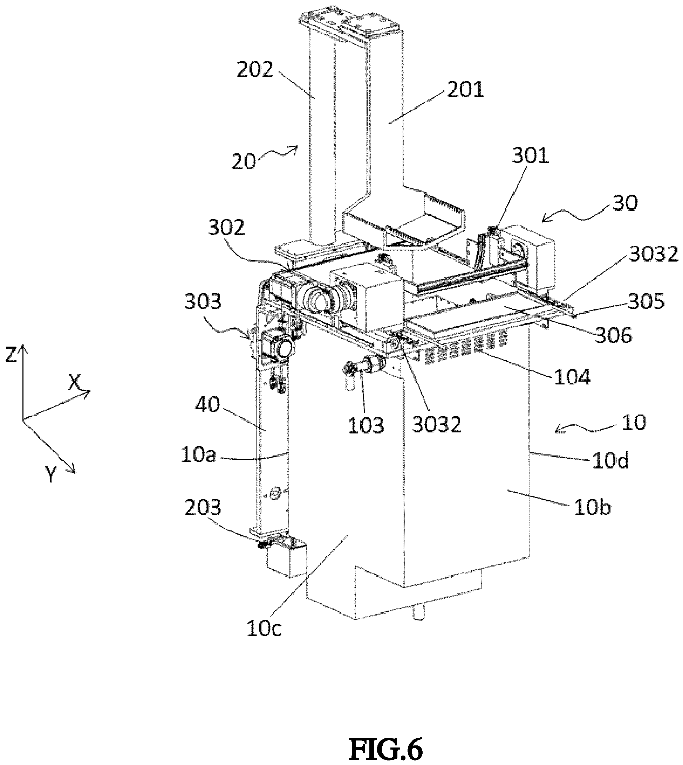

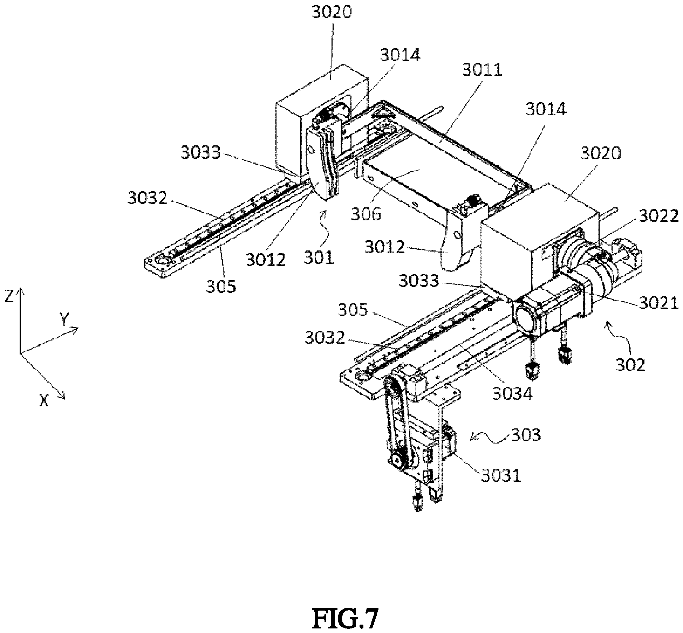

Fig. 6 shows an overall structural diagram of the substrate turn-over device, wherein the housing of the turn-over mechanism is hidden. Fig. 7 shows the internal structure of the turn-over mechanism. As shown in Figs. 6 and 7, the turn-over mechanism 30 includes a substrate holder 301, a second driving assembly 302, and a third driving assembly 303. The substrate holder 301 for holding the substrate is disposed laterally on the top part of the tank 10. As shown in Fig. 6, the substrate holder 301 spans the top opening of the tank 10 and is parallel to the first sidewall 10a or the second sidewall 10b of the tank 10. The substrate holder 301 is connected to a second driving assembly 302 for driving the substrate holder 301 to rotate. In the present embodiment, the second driving assembly 302 is mounted on the third driving assembly 303, and the third driving assembly 303 can drive the substrate holder 301 to translate between the substrate-receiving position and the substrate-taking position by driving the second driving assembly 302 to translate.

The substrate holder 301 receives the substrate from the support seat 201 at the substrate-receiving position. Specifically, when the substrate holder 301 is moved to the substrate-receiving position under the drive of the third driving assembly 303, the substrate holder 301 is located below the support seat 201 and faces at least a part of the substrate on the support seat 201. At least a part of the substrate will be transferred to the substrate holder 301 during the lowering of the support seat 201. When the substrate holder 301 moves to the substrate-taking position under the drive of the third driving assembly 303, the substrate holder 301 is away from the support seat 201. The substrate holder 301 and the support seat 201 do not interfere with each other. The substrate holder 301 can perform a substrate turn-over operation at the substrate-taking position. Specifically, the substrate holder 301 turns the substrate from the vertical direction to the horizontal direction, so that the process manipulator horizontally takes out the substrate from the substrate holder 301 and transfers it to the single substrate cleaning module. In other embodiments, the substrate holder 301 can be moved to a position between the substrate-receiving position and the substrate-taking position to perform the substrate turn-over operation. Or the substrate holder 301 may perform the substrate turn-over operation synchronously in the process of moving from the substrate-receiving position to the substrate-taking position.

The turn-over mechanism 30 is further provided with a second liquid receiving slot 306 on one side of the tank 10 close to the substrate-taking position. The second liquid receiving slot 306 can be fixed on the sidewall of the tank 10. As shown in Fig. 6, the second liquid receiving slot 306 is fixed on the top part of the second sidewall 10b. When the substrate holder 301 rotates the substrate from the vertical direction to the horizontal direction, or when the process manipulator takes the substrate from the substrate holder 301, the second liquid receiving slot 306 can receive the liquid dripped from the substrate to keep the internal environment of the apparatus clean.

In the present embodiment, as shown in Fig. 7, the second driving assembly 302 may include a second driving motor 3021 and a speed reduction coupling 3022. The third driving assembly 303 may include a third driving motor 3031, a third slide rail 3032, a third slide seat 3033, and a third lead screw 3034. The second driving motor 3021 is connected to the rotating shaft 3014 of the substrate holder 301 through a speed reduction coupling 3022 to drive the substrate holder 301 to rotate. The third driving assembly 303 is configured with two third slide rails 3032, which are respectively fixed on two sides of the water tank 10. Specifically, the two third slide rails 3032 are respectively arranged on the outside of the third sidewall 10c and the fourth sidewall 10d of the water tank 10, and each third slide rail 3032 is provided with a third slide seat 3033. In the first embodiment, the third driving motor 3031 drives the third slide seat 3033 to translate along the third slide rail 3032 through the pulley and the third lead screw 3034. The substrate holder 301 and the second driving assembly 302 are integrally fixed to the third slide seat 3033 by the mounting bracket 3020, so that the substrate holder 301 and the second driving assembly 302 are driven to translate by the third driving assembly 303.

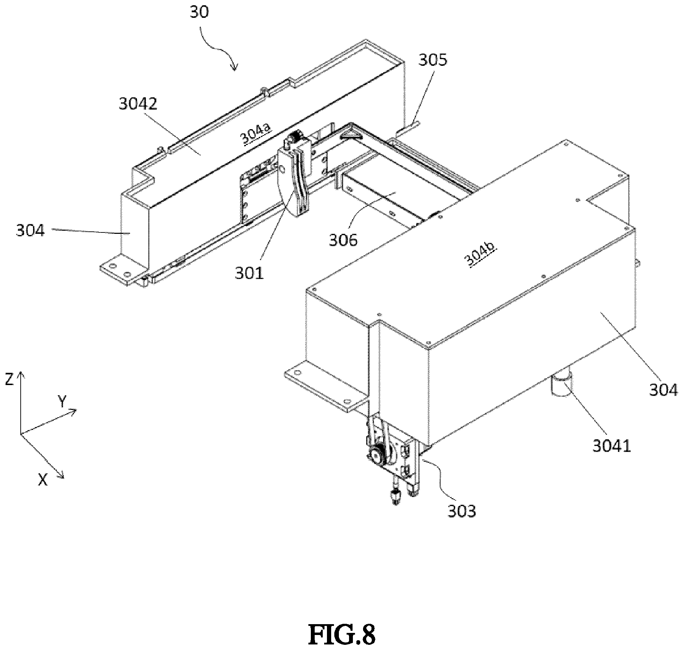

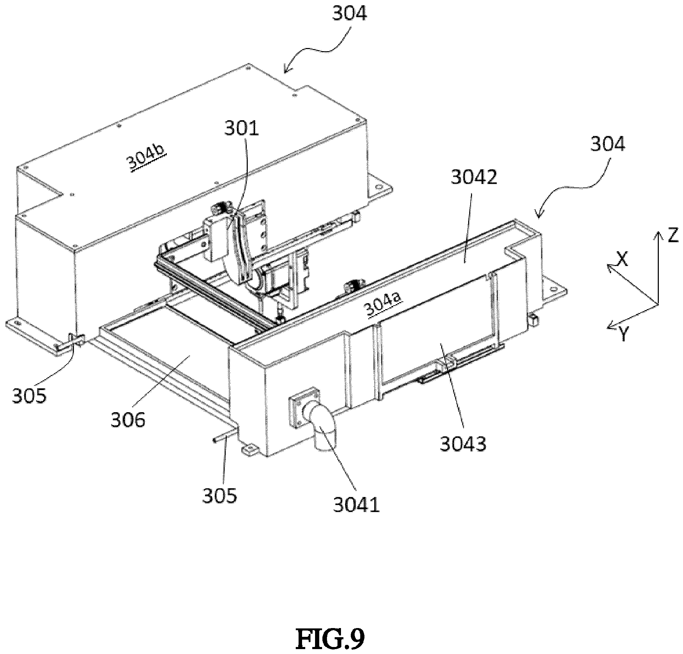

Figs. 8 and 9 show structural diagrams of the turn-over mechanism. As shown in Figs. 8 and 9, the turn-over mechanism 30 further includes a housing 304 in which the second drive assembly 302 and the third drive assembly 303 are disposed. Accordingly, the second drive assembly 302 and the third drive assembly 303 can be prevented from being corroded by the chemical liquid. As shown in Fig. 6, the third slide rail 3032 of the third drive assembly 303 is provided on the outside of the third sidewall 10c and the fourth sidewall 10d of the tank 10. In order to protect the second drive assembly 302 and the third drive assembly 303, the housing 304 is divided into two parts, which are denoted as a first housing 304a and a second housing 304b as shown in Figs. 8 and 9. In the present embodiment, as shown in Fig. 1, the first housing 304a is disposed on the outside of the fourth sidewall 10d, and the second housing 304b is disposed on the outside of the third sidewall 10c.

Please refer again to Figs. 8 and 9, in order to further reduce the damage of the external environment to the second driving assembly 302 and the third driving assembly 303, the housing 304 is further provided with an intake pipe 305 for supplying positive pressure gas into the housing 304, thereby preventing the external environment gas from entering the housing 304. In addition, the housing 304 is further provided with an exhaust port 3041 connecting with the facility exhaust system to discharge the gas inside the housing 304, so as to keep the micro-environment inside the housing 304 clean.

The top part of the housing 304, particularly the top part of the housing 304 located below the transfer path of manipulator, such as the top part of the first housing 304a, can be recessed inwardly to form a first liquid receiving slot 3042. A flow guide tank 3043 is formed on the sidewall of the housing 304 away from the tank 10, and the flow guide tank 3043 is connected to the first liquid receiving slot 3042 to guide the liquid in the first liquid receiving slot 3042 to the outside of the substrate turn-over device. In the first embodiment, one side of the substrate turn-over device is a substrate cleaning tank, and the guide tank 3043 guides the liquid in the first liquid receiving slot 3042 to the substrate cleaning tank. In the present embodiment, the other side of the substrate turn-over device is an electronic control equipment area, which belongs to the dry area. Therefore, the second housing 304b is not provided with the first liquid receiving slot 3042 and the guide tank 3043. In other embodiments, two parts of the housing 304, that is, the first housing 304a and the second housing 304b, can be equipped with the first liquid receiving slot 3042 and the flow guide tank 3043 according to the equipment layout requirements.

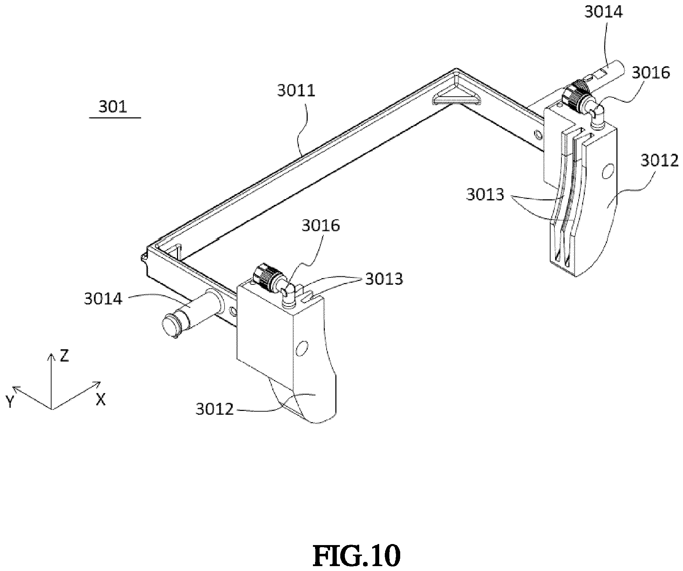

Please refer to Figs. 10 to 12, the substrate holder 301 includes a connecting member 3011 and clamping parts 3012 provided in pairs. The connecting member 3011 has oppositely arranged sidewalls. The clamping parts 3012 arranged in pairs are detachably installed at the ends of the two sidewalls of the connecting member 3011 respectively. At least a pair of clamping slots 3013 are provided in pairs on the opposite sides of the two clamping parts 3012. Each pair of clamping slots 3013 is used for receiving one substrate. The backing surfaces of the two sidewalls of the connecting member 3011 are provided with a rotating shaft 3014, and the second driving assembly 302 drives the substrate holder 301 to rotate through the rotating shafts 3014. Some chemical liquid or contaminants may be accumulated in the clamping slots 3013 of the clamping parts 3012. In order to keep the clamping slots 3013 clean, each clamping slots 3013 is provided with a cleaning channel 3015, and the cleaning liquid is supplied to the clamping slots 3013 through the cleaning channel 3015 to clean the clamping slots 3013. One end of the cleaning channel 3015 is connected with the clamping slots 3013, and the other end is connected to a liquid inlet pipe 3016. In the first embodiment, the liquid supply pipe 103 that supplies deionized water to the inner tank 101 can be connected with the liquid inlet pipe 3016 through a branch pipe (not shown) to provide deionized water to the clamping slot 3013 so as to clean the clamping slot 3013.

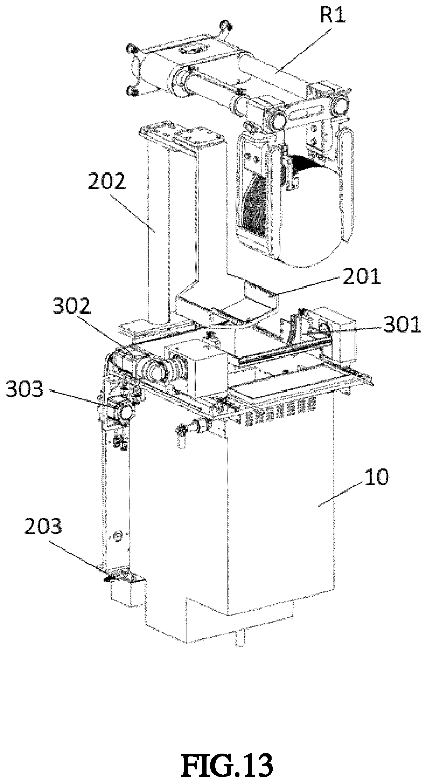

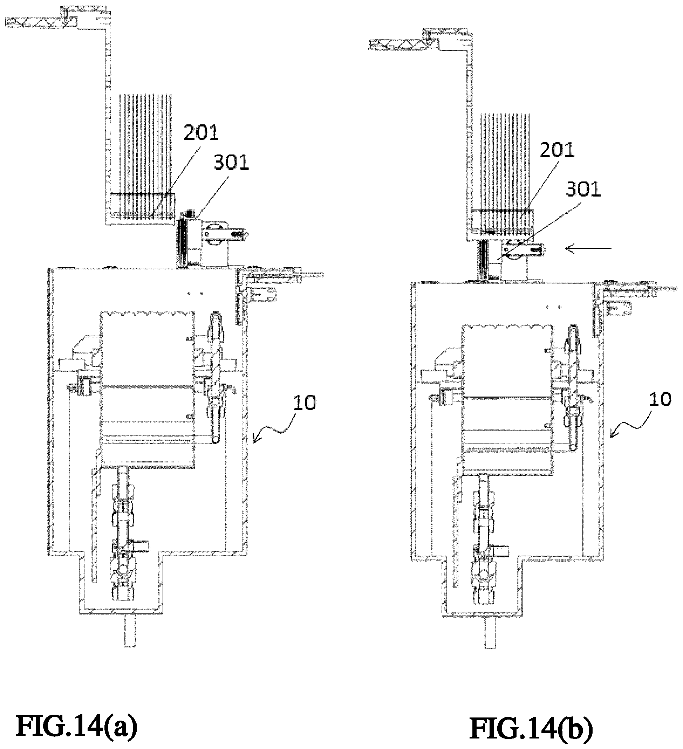

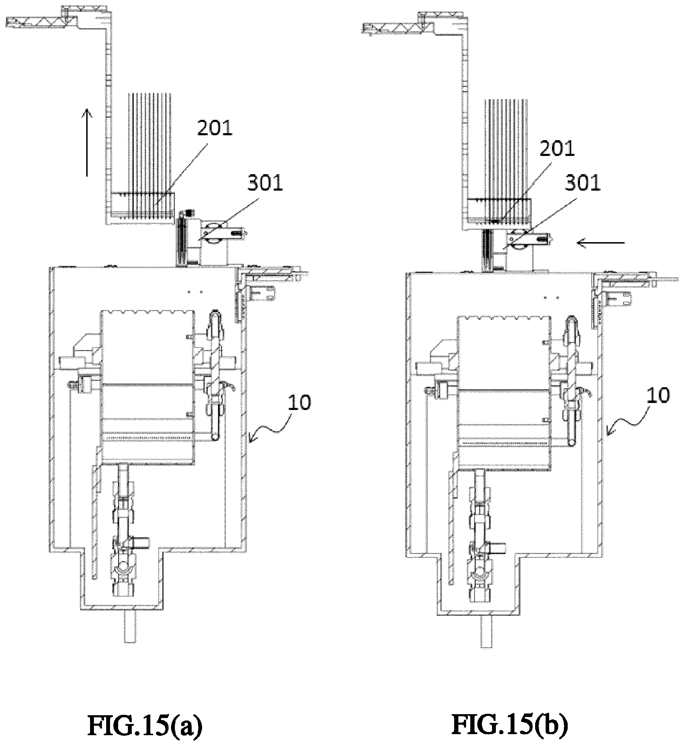

The operation steps of the substrate turn-over device will be described below with reference to Figs. 14 (a) to 14 (h) and 15 (a) to 15 (h), in which the lifting mechanism is simplified and only the support seat 201 is retained. When the substrate turn-over device is in the initial state, as shown in Fig. 13, the support seat 201 is empty, lifted from the tank 10, located at the substrate-placing position, and prepared to receive the substrate transferred by the manipulator R1; The substrate holder 301 is empty and rotates in the vertical direction, and is located at the substrate-taking position. Hereinafter, for convenience of description, it will be described that the support seat 201 can receive 13 substrates and the substrate holder 301 can receive 2 substrates as an example.

Step 1, the support seat 201 receives the substrates. As shown in Figs. 13 and 14 (a), the support seat 201 is lifted to the substrate-placing position, the manipulator R1 places a plurality of substrates (for example, 13 substrates) on the support seat 201, and then the manipulator R1 is taken out.

Step 2, the substrate holder 301 is moved to the substrate-receiving position. As shown in Fig. 14 (b), the substrate holder 301 translates toward the support seat 201, and moves from the substrate-taking position away from the support seat 201 to the first substrate-receiving position directly below the support seat 201. The substrate holder 301 directly faces the two substrates on the support seat 201 at this time. In the first embodiment, the substrate holder 301 starts to take substrates from the leftmost end of the support seat 201, and the substrate holder 301 corresponds to the two substrates on the leftmost end of the support seat 201 at the first substrate-receiving position.

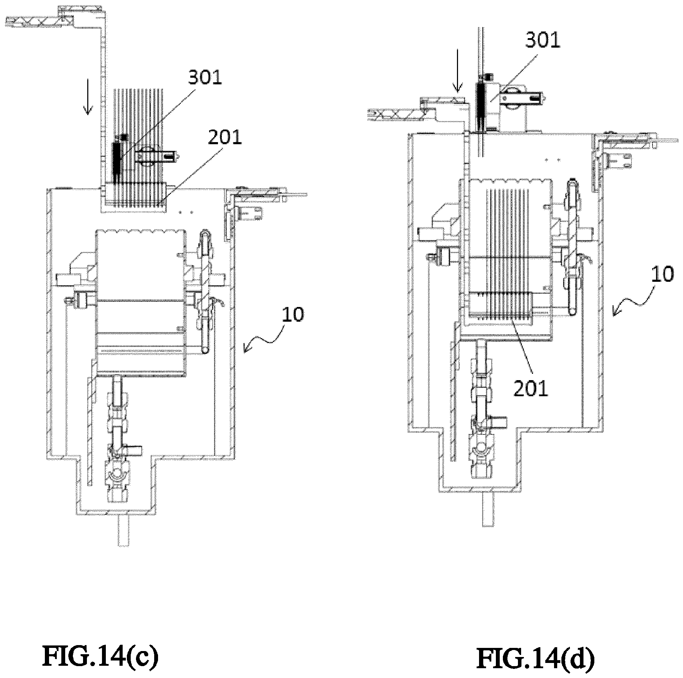

Step 3, the substrate holder 301 receives the substrates. After the substrate holder 301 is moved to the substrate-receiving position, as shown in Fig. 14 (c), the support seat 201 starts to descend, and the substrate holder 301 receives two substrates, and then, as shown in Fig. 14 (d), the support seat 201 continues to descend into the tank 10. During the substrate-receiving process of the substrate holder 301, the support seat 201 is lowered at a first speed, and after the substrate holder 301 receives the substrates, the support seat 201 is lowered into the tank 10 at a second speed, so that the remaining substrates on the support seat 201 is completely immersed in the liquid of the tank 10. The first speed is less than the second speed, so as to avoid damage caused by collision between the substrates and the substrate holder 301 when the support seat 201 is lowered too fast.

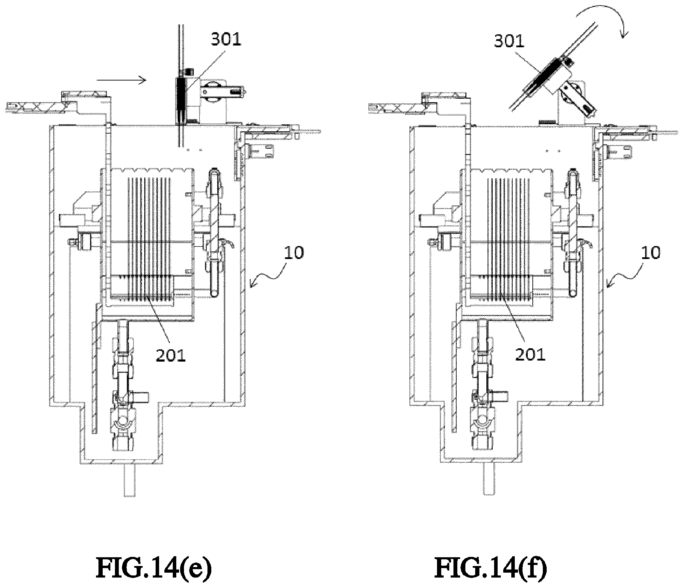

Step 4, the substrate holder 301 is moved to the substrate-taking position. After the support seat 201 is lowered to the tank 10, as shown in Fig. 14 (e), the substrate holder 301 carries two substrates and moves from the substrate-receiving position to the substrate-taking position.

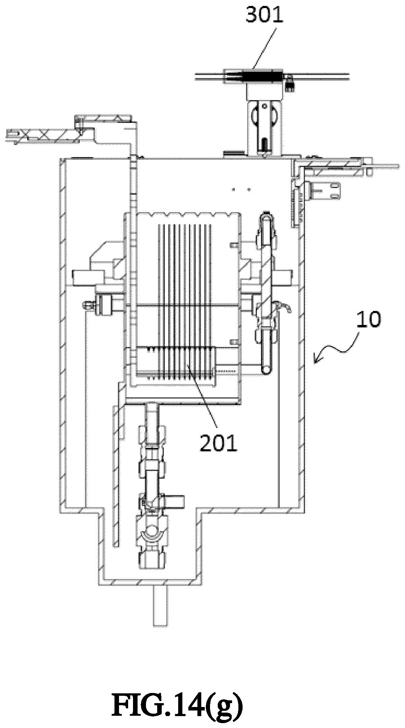

Step 5, the substrate holder 301 performs an overturning operation. As shown in Figs. 14 (f) and 14 (g), the substrate holder 301 slowly turns the substrates from the vertical direction to the horizontal direction at the substrate-taking position. During this process, the substrate holder 301 slowly turns the substrates from the vertical direction to the horizontal direction at a third speed. The third speed is 10° ~50 ° /s.

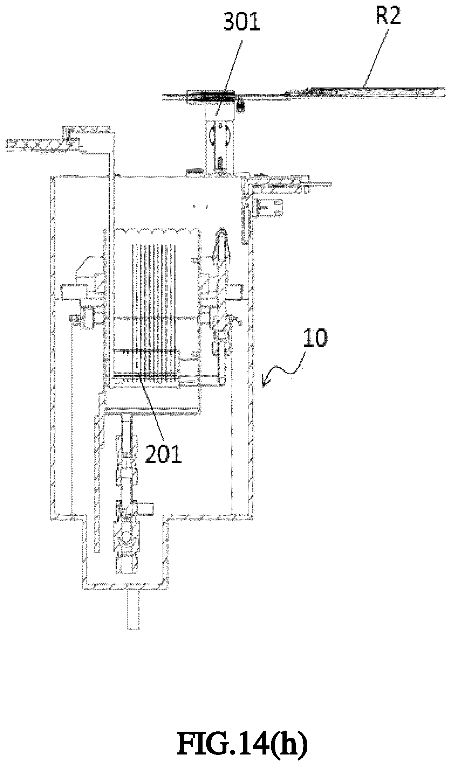

Step 6, the process manipulator takes the substrates. When the substrate holder 301 turns the substrates in the horizontal direction, as shown in Fig. 14 (h), the process manipulator R2 takes the substrates away from the substrate holder 301.

Step 7, the substrate turn-over device is restored to the initial state. As shown in Fig. 15 (a), the support seat 201 is lifted to the substrate-placing position again, and the empty substrate holder 301 is quickly overturned from the horizontal direction to the vertical direction to return to the initial state. Preferably, since the substrate holder 301 and the support seat 201 do not interfere with each other at the substrate-taking position, the operation of the support seat 201 lifting to the substrate-placing position again can be synchronized with the operation of the substrate holder 301 performing the overturning operation at the substrate-taking position and the operation of the process manipulator taking the substrates, so that the substrate transmission efficiency of the substrate turn-over device can be improved. In step 7, the substrate holder 301 is empty and quickly overturned from the vertical direction to the horizontal direction at a fourth speed. The fourth speed is greater than the third speed. The fourth speed is 90 ° ~ 180 ° /s.

Step 8, the substrate holder 301 is moved to the substrate-receiving position. As shown in Fig. 15 (b), the substrate holder 301 translates toward the support seat 201 and moves from the substrate-taking position to the second substrate-receiving position. At this time, the substrate holder 301 directly faces the other two substrates on the support seat 201. The second substrate-receiving position is immediately adjacent to the first substrate-receiving position, so that the substrate holder 301 receives the substrates on the support seat 201 in sequential order from left to right, and the control logic of the operation of the substrate holder 301 is simplified. Of course, in other embodiments, the substrate holder 301 can also receive the substrates on the support seat 201 in sequential order from right to left.

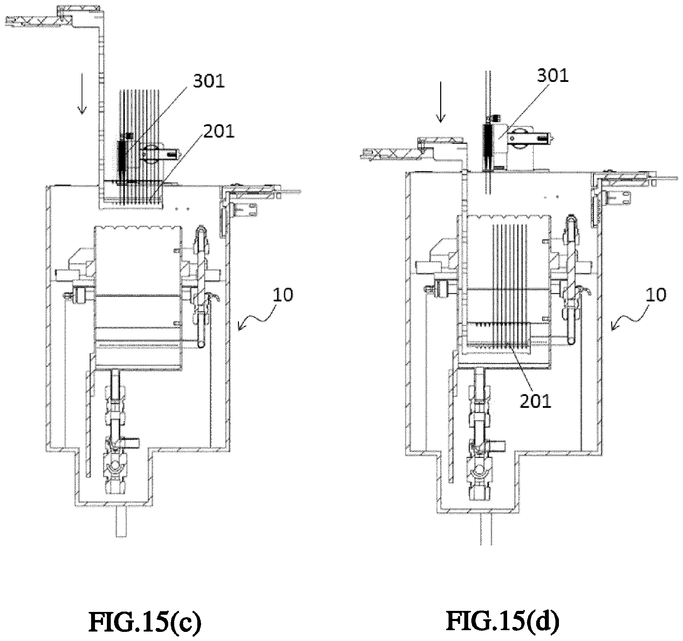

Step 9, the substrate holder 301 receives the substrates. After the substrate holder 301 is moved to the substrate-receiving position, as shown in Figs. 15 (c) and 15 (d), the support seat 201 starts to descend at the first speed, and the substrate holder 301 receives two substrates, after which the support seat 201 continues to descend to the tank 10 at the second speed, wherein the first speed is less than the second speed.

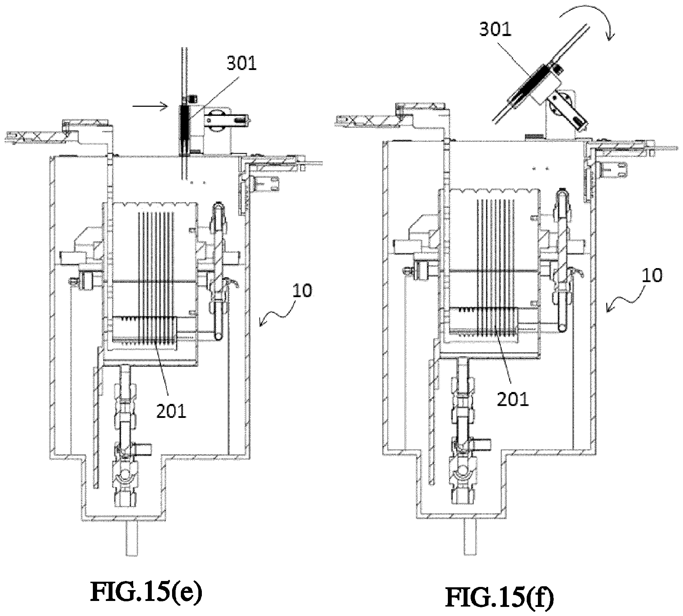

Step 10, the substrate holder 301 is moved to the substrate-taking position. After the support seat 201 is lowered to the tank 10, as shown in Fig. 15 (e), the substrate holder 301 carries two substrates and moves from the substrate-receiving position to the substrate-taking position.

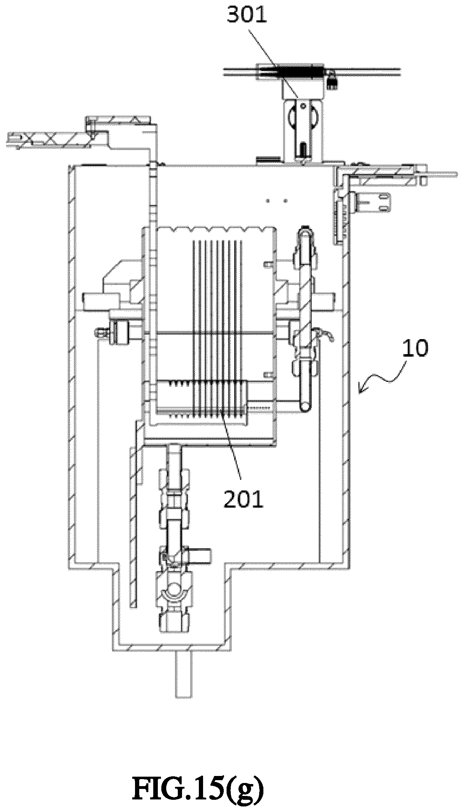

Step 11, the substrate holder 301 performs an overturning operation. As shown in Figs. 15 (f) and 15 (g), the substrate holder 301 slowly overturns the substrates from the vertical direction to the horizontal direction at the third speed at the substrate-taking position.

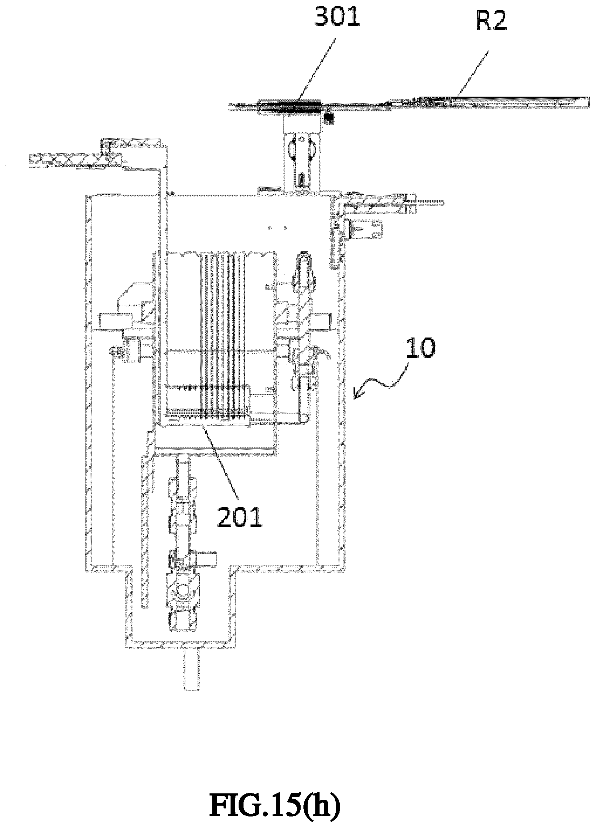

Step 12, the process manipulator takes the substrates. When the substrate holder 301 overturns the substrates in the horizontal direction, as shown in Fig. 15 (h), the process manipulator R2 takes the substrates away from the substrate holder 301.

Next, steps 7 to 12 are repeated until the substrate holder 301 removes all the substrates on the support seat 201. In the present embodiment, the support seat 201 receives 13 substrates, and the substrate holder 301 can transfer 2 substrates at a time. Therefore, the substrate holder 301 needs to repeat the operation of receiving the substrates from the support seat 201 seven times, receiving 2 substrates at a time for the first six times, and receiving 1 substrate at a time for the seventh time. By analogy, if the support seat 201 receives seven substrates, the substrate holder 301 needs to repeat the operation of receiving the substrates from the support seat 201 four times; If the support seat 201 receives 25 substrates, the substrate holder 301 needs to repeat the operation of receiving the substrates from the support seat 201 thirteen times.

As a preferred solution, the number of substrates that the substrate holder 301 can receive matches the number of substrates taken by the process manipulator, thereby improving the utilization rate of the process manipulator. For example, when the process manipulator is equipped with two arms, the number of clamping slots 3013 that the substrate holder 301 can receive is not less than two pairs, that is, the number of substrates that the substrate holder 301 can receive is not less than two. And for example, when the process manipulator is equipped with three arms, the number of substrates that the substrate holder 301 can receive is not less than three.

In the substrate turn-over device, the support seat 201 can receive a plurality of substrates, so that the substrates that have completed tank cleaning can be transferred to the substrate turn-over device at one time, and the residence time of the substrates in the substrate cleaning tank can be reduced, thereby increasing the output of the substrate cleaning apparatus.

At the same time, the substrate holder 301 is configured not only to rotate the substrates from the vertical direction to the horizontal direction, but also to translate relative to the support seat 201. By moving back and forth at the substrate-receiving position and the substrate-taking position, a plurality of substrates on the support seat 201 can be quickly transferred to the process manipulator R2 in a plurality of times, which is beneficial to improve the substrate transferring speed of the substrate turn-over device.

In addition, when the substrate holder 301 transfers the substrates to the process manipulator R2, the substrates stayed on the support seat 201 can be lowered and immersed in the liquid of the tank 10 along with the support seat 201, so as to remain wet, thereby shortening the exposure time of the substrates in the air and preventing contaminants such as particles in the air from contaminating the surface of the substrates.

### Second embodiment

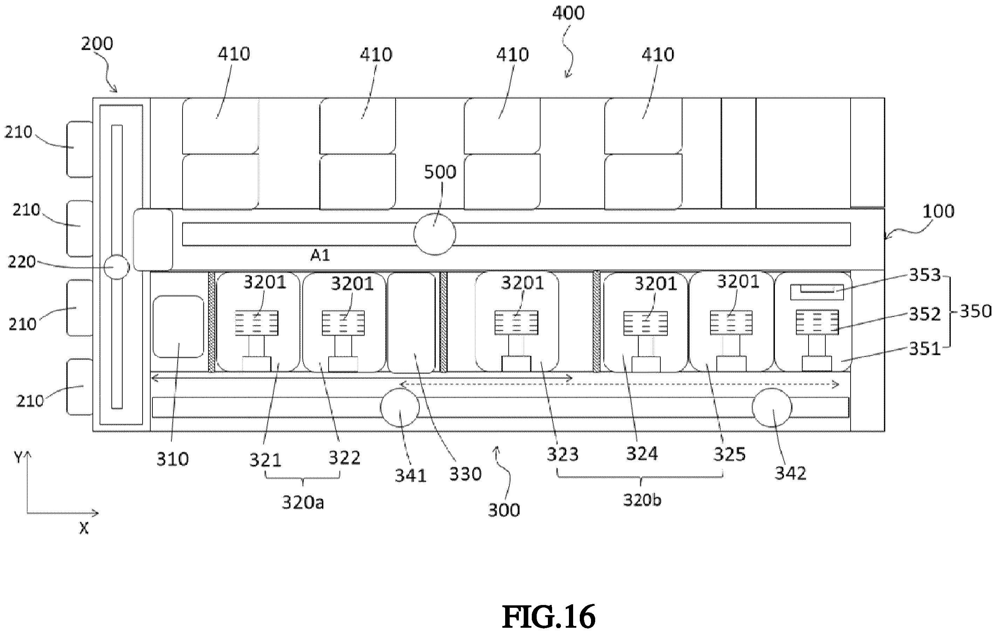

Please refer to Fig. 16, a substrate cleaning apparatus according to the second embodiment of the present invention is disclosed. The substrate cleaning apparatus includes a main body frame 100, a front-end device module 200, a tank cleaning module 300, a single substrate cleaning module 400, and a process manipulator 500.

The front-end device module 200 includes a plurality of loading ports 210 and a front-end manipulator 220. The plurality of loading ports 210 arranged longitudinally in the Y direction are used to accommodate a substrate box in which a plurality of substrates are accommodated, and typically, 25 substrates are accommodated in the substrate box. The front-end manipulator 220 is used to transfer the substrates from the front-end device module 200 to the tank cleaning module 300 for the tank cleaning process, or transfer the substrates that have completed the single substrate cleaning process and drying process from the single substrate cleaning module 400 back to the front-end device module 200.

The tank cleaning module 300 includes a first turn-over device 310, at least one substrate cleaning tank (321-325), at least one manipulator (341, 342), and a second turn-over device 350. The first turn-over device 310, the at least one substrate cleaning tank (321 to 325), and the second turn-over device 350 are arranged laterally in the X direction orderly. The first turn-over device 310 is close to the front-end device module 200. The front-end manipulator 220 horizontally transmits the substrates to the first turn-over device 310. The first turn-over device 310 is used to rotate the substrates from the horizontal direction to the vertical direction. At least one substrate cleaning tank (321-325) is configured to perform a tank cleaning process on the substrates. At least one manipulator (341, 342) is responsible for vertically transferring the substrates for the first turn-over device 310, the at least one substrate cleaning tank (321-325) and the second turn-over device 350. The second turn-over device 350 is used to rotate the substrates from the vertical direction to the horizontal direction so that the process manipulator 500 horizontally transfers the substrates to the single substrate cleaning module 400.

The second turn-over device 350 has the same structure as the substrate turn-over device in the first embodiment, with a tank 351, a lifting mechanism 352, and a turn-over mechanism 353. After the second turn-over device 350 receives a plurality of substrates at one time by the lifting mechanism 352, then part of the substrates are transferred to the turn-over mechanism 353, which rotates the substrates from the vertical direction to the horizontal direction. Then the substrates are taken out from the turn-over mechanism 353 by the process manipulator 500, and transferred to the single substrate cleaning module 400, and the single substrate cleaning process and drying process are performed on the substrates in the single substrate cleaning chamber 410.

The number of substrates that the turn-over mechanism 353 can accommodate can be determined according to the number of robotic arms configured in the process manipulator 500. Generally, the number of substrates that the turn-over mechanism 353 can accommodate is not less than the number of robotic arms configured in the process manipulator 500. The number of robotic arms configured in the process manipulator 500 is determined according to the number of single substrate cleaning chambers 410 configured in the single substrate cleaning module 400. For example, when eight single substrate cleaning chambers 410 are configured, the process manipulator 500 equipped with two robotic arms is selected between the second turn-over device 350 and the single substrate cleaning module 400 in consideration of comprehensive transmission efficiency and equipment cost. At the same time, the turn-over mechanism 353 is configured to accommodate at least two substrates.

In the present embodiment, each of the substrate cleaning tanks (321 to 325) is provided with a lifting mechanism 3201. The lifting mechanism 3201 disposed in the substrate cleaning tanks (321 to 325) has the same structure as the lifting mechanism 352 disposed in the second turn-over device 350. According to the introduction of the first embodiment, the lifting mechanism 3201 is independently disposed relative to the substrate cleaning tanks (321-325), so that the installation position of the lifting mechanism in each substrate cleaning tank can be independently adjusted. Specifically, each substrate cleaning tank can make the support seat of the lifting mechanism 3201 directly face the substrate-placing position through the micro-adjustment assembly configured by the lifting mechanism 3201. The substrate-placing position is the position where the lifting mechanism 3201 receives the substrates from at least one manipulator (341, 342). The specific configuration of the lifting mechanism 3201 is described in the first embodiment, and will not be repeated here.

In the first embodiment, a plurality of substrate cleaning tanks are provided. The plurality of substrate cleaning tanks (321-325) are divided into at least two groups, and each group of substrate cleaning tanks is equipped with at least one manipulator. A manipulator cleaning tank is arranged between two adjacent groups of substrate cleaning tanks, and the manipulator cleaning tanks are used for cleaning the manipulator arranged in the two adjacent groups of substrate cleaning tanks. Each group of substrate cleaning tanks can include at least one chemical liquid tank and at least one water tank. The chemical liquid tank contains chemical liquid, such as HF, SPM, etc. The water tank contains DIW. Usually, the substrate is placed in the chemical liquid tank for cleaning firstly, then transferred to the water tank for cleaning, and then transferred to the chemical liquid tank of the next group of substrate cleaning tanks for cleaning. The number of chemical liquid tanks and water tanks configured for each group of substrate cleaning tanks is determined according to the actual situation of the process.

As shown in Fig. 16, the plurality of substrate cleaning tanks (321 to 325) are divided into two groups, which are a first group of substrate cleaning tanks 320a and a second group of substrate cleaning tanks 320b, respectively. The plurality of manipulators include a first manipulator 341 that transfers a substrate in the first group of substrate cleaning tanks 320a, and a second manipulator 342 that transfers a substrate in the second group of substrate cleaning tanks 320b. The second manipulator 342 is also responsible for transferring the substrate that has completed tank cleaning in the second group of substrate cleaning tanks 320b to the lifting mechanism 352 of the second turn-over device 350. One manipulator cleaning tank 330 is disposed between the first group of substrate cleaning tanks 320a and the second group of substrate cleaning tanks 320b, and the manipulator cleaning tank 330 can clean the first manipulator 341 and the second manipulator 342.

The single substrate cleaning module 400 and the tank cleaning module 300 are arranged opposite each other. In the first embodiment, the single substrate cleaning module 400 is provided with a plurality of single substrate cleaning chambers 410 which are arranged in the horizontal X direction. The single substrate cleaning chamber 410 is used to perform single substrate cleaning process and drying process on a substrate. The process manipulator 500 is disposed between the tank cleaning module 300 and the single substrate cleaning module 400. The process manipulator 500 is used to take out the substrate from the turn-over mechanism 353 of the second turn-over device 350 of the tank cleaning module 300 and horizontally transfer the substrate to the single substrate cleaning chamber 410. In addition, the process manipulator 500 is also responsible for transferring the substrate that has completed single substrate cleaning process and drying process back to the front-end equipment module 200.

In the substrate cleaning apparatus according to the second embodiment, the second turn-over device 350 adopts the substrate turn-over device according to the first embodiment. The lifting mechanism 352 of the second turn-over device 350 and the lifting mechanism arranged in the substrate cleaning tanks (321 to 325) have the same structure, so that the number of substrates received by the second turn-over device can be the same as the number of substrates processed by the substrate cleaning tank in a single time. And then the second turn-over device and the substrate cleaning tank can share the same manipulator. For example, in Fig. 16, the substrate cleaning tanks 323, 324, and 325 share the second manipulator 342 with the second turn-over device 350. It reduces the number of manipulators arranged in the substrate cleaning apparatus, which is beneficial to cost savings. In addition, the substrates that have completed tank cleaning process in the tank cleaning module 300 do not need to stay in the substrate cleaning tank and wait to enter the second turn-over device, and can be transferred to the lifting mechanism 352 in the second turn-over device 350 at one time. It reduces the occupation time of the substrates in the substrate cleaning tank, makes the substrate cleaning tank vacant in time to receive the next batch of substrates to be cleaned, and improves the efficiency of the substrate cleaning apparatus.

When the turn-over mechanism 353 in the second turn-over device 350 rotates the substrates, the lifting mechanism 352 can carry the remaining substrates stagnant thereon into the immersion tank 351 to keep the surface of the substrates wet and avoid adhesion of the contaminants such as particles.

In addition, the substrate cleaning apparatus disposes a manipulator cleaning tank 330 between two adjacent groups of substrate cleaning tanks, which facilitates cleaning of the plurality of manipulators (341, 342), keeps each manipulator clean, reduces contamination of the substrate by impurities on the manipulators (341, 342), which is beneficial to improve the yield of the substrate cleaning apparatus.

In summary, the present invention has disclosed the relevant technology specifically and in detail through the above-described embodiments and related diagrams, so that those skilled in the art can implement it accordingly. However, the above description is intended only to explain the present invention, and should not be considered as limiting the present invention. The protection scope of the present invention should be defined by the attached claims. Any modification in the number of elements or substitution of equivalent elements described herein should still fall within the scope of the present invention.

## Claims

1. A substrate turn-over device, comprising:
a tank, for holding liquid;
a lifting mechanism, arranged on one side of the tank, configured to receive the substrate and drive the substrate up and down so as to submerge the substrate in the liquid of the tank or lift the substrate from the tank;
a turn-over mechanism, arranged on the tank for overturning the substrate and configured to move between a substrate-receiving position and a substrate-taking position relative to the lifting mechanism, wherein the substrate-receiving position is a position where the turn-over mechanism receives the substrate from the lifting mechanism, and the substrate-taking position is a position where the substrate is taken out from the turn-over mechanism.

2. The substrate turn-over device according to claim 1, wherein the tank is provided with an exhaust port connecting to a facility exhaust system, the exhaust port comprises a first exhaust plate and a second exhaust plate, a cavity is formed between the first exhaust plate and the second exhaust plate, and the first exhaust plate and the second exhaust plate are provided with staggered exhaust holes.

3. The substrate turn-over device according to claim 1, wherein the lifting mechanism comprises a support seat, a support rod and a first driving assembly, one end of the support seat is used for receiving the substrate, the other end of the support seat is fixed on the support rod, and the first driving assembly drives the support seat to ascend and descend through the support rod.

4. The substrate turn-over device according to claim 3, wherein the lifting mechanism further comprises a micro-adjusting assembly, and the micro-adjusting assembly is used to make the support seat of the lifting mechanism directly opposite the substrate-placing position, the substrate-placing position is a position where the lifting mechanism receives the substrate from a manipulator.

5. The substrate turn-over device according to claim 4, wherein the micro-adjusting assembly comprises a first micro-adjusting assembly, the lifting mechanism is mounted on a mounting plate through the first micro-adjusting assembly, and the first micro-adjusting assembly adjusts the mounting position of the lifting mechanism in a first direction, so that the support seat of the lifting mechanism is directly opposite the substrate-placing position.

6. The substrate turn-over device according to claim 5, wherein the first micro-adjusting assembly comprises a transverse guide rail, a slider, a first fastener and a micro-adjusting set screw, the transverse guide rail is arranged in the first direction, the lifting mechanism is slidably installed on the transverse guide rail through the slider, one end of the micro-adjusting set screw is in contact with the lifting mechanism, and when the micro-adjusting set screw pushes the lifting mechanism to move in the first direction and adjust to a predetermined position, the lifting mechanism is fixed at the predetermined position through the first fastener.

7. The substrate turn-over device according to claim 4, wherein the micro-adjusting assembly comprises a second micro-adjusting assembly, the support seat is mounted on the support rod by the second micro-adjusting assembly, and the mounting position of the support seat in a second direction is adjusted by the second micro-adjusting assembly, so that the support seat is directly opposite the substrate-placing position.

8. The substrate turn-over device according to claim 7, wherein the second micro-adjusting assembly comprises a second fastener, a first adjusting member and a second adjusting member, the first adjusting member and the second adjusting member are arranged in the second direction, one end of the first adjusting member is fixed on the support rod, one end of the second adjusting member is fixed on the support seat, adjustment holes are provided on the other ends of both the first adjusting member and the second adjusting member, and the first adjusting member and the second adjusting member are fixed together via the second fastener passing through the overlapping portions of the adjustment holes of the first adjusting member and the second adjusting member.

9. The substrate turn-over device according to claim 1, wherein the turn-over mechanism comprises a substrate holder, a second driving assembly and a third driving assembly, the substrate holder is transversely arranged at the top part of the tank, the second driving assembly is used for driving the substrate holder to rotate, and the third driving assembly is used for driving the substrate holder to move between the substrate-receiving position and the substrate-taking position relative to the lifting mechanism.

10. The substrate turn-over device according to claim 9, wherein the substrate holder is provided with at least one pair of clamping slots, each clamping slot is provided with a cleaning channel, and cleaning liquid is supplied to the clamping slots through the cleaning channels to clean the clamping slots.

11. The substrate turn-over device according to claim 9, wherein the turn-over mechanism further comprises a housing, the second driving assembly and the third driving assembly are located inside the housing, a first liquid receiving slot is provided at the top part of the housing, a diversion slot is formed on a sidewall of the housing deviating from the tank, and the diversion slot is connected with the first liquid receiving slot to guide the liquid in the first liquid receiving slot to the outside.

12. The substrate turn-over device of claim 11, wherein the housing is further provided with an intake pipe for supplying positive pressure gas to the housing.

13. The substrate turn-over device according to claim 11, wherein the housing is provided with an exhaust port for connecting the facility exhaust system.

14. The substrate turn-over device according to claim 1, wherein the turn-over mechanism further comprises a second liquid receiving slot, and the second liquid receiving slot is arranged on the sidewall of the tank near the substrate-taking position.

15. A substrate cleaning apparatus, comprising:
a tank cleaning module, comprising a first turn-over device, at least one substrate cleaning tank, at least one manipulator and a second turn-over device, the at least one substrate cleaning tank being used for performing a tank cleaning process on the substrate, the first turn-over device being used for overturning the substrate from a horizontal direction to a vertical direction, the at least one manipulator being responsible for vertically transferring the substrate for the first turn-over device, at least one substrate cleaning tank and the second turn-over device, and the second turn-over device being used for overturning the substrate that has completed tank cleaning from the vertical direction to the horizontal direction;
a single substrate cleaning module, comprising at least one single substrate cleaning chamber for performing single substrate cleaning process and drying process on the substrate;
a process manipulator, taking the substrate from the second turn-over device and horizontally transferring the substrate into at least one single substrate cleaning chamber of the single substrate cleaning module;
wherein, the second turn-over device adopts the substrate turn-over device according to any one of claims 1 to 14.

16. The substrate cleaning apparatus according to claim 15, wherein each substrate cleaning tank is provided with a lifting mechanism, and the lifting mechanism disposed in the substrate cleaning tank is the same as the lifting mechanism disposed in the second turn-over device.

17. The substrate cleaning apparatus according to claim 15, wherein the number of substrate cleaning tanks is multiple, the plurality of substrate cleaning tanks are divided into at least two groups, each group of substrate cleaning tanks is equipped with a manipulator, a manipulator cleaning tank is arranged between two adjacent groups of substrate cleaning tanks, and the manipulator cleaning tanks are used for cleaning the manipulators respectively arranged in two adjacent groups of substrate cleaning tanks.
